# FASCICULE DE BREVET EUROPEEN

(11) **EP 0 568 466 B1**
(45) Date de publication et mention de la délivrance du brevet: **09.06.1999**
(21) Numéro de dépôt: 93420120.3
(22) Date de dépôt: 17.03.1993
(51) Int. Cl.: H01L 29/866

(54) **Diode à avalanche enterrée**
Vergrabener Lawinendiode
Burried avalanche diode

(30) Priorité: 20.03.1992 FR 9203762
(43) Date de publication de la demande: 03.11.1993
(73) Titulaire: STMicroelectronics S.A., 94250 Gentilly (FR)
(72) Inventeur: Jimenez, Jean, F-38500 Voiron (FR)
(74) Mandataire: de Beaumont, Michel

(56) Documents cités:
- PATENT ABSTRACTS OF JAPAN vol. 7, no. 170 (E-189)27 Juillet 1983
- PATENT ABSTRACTS OF JAPAN vol. 8, no. 119 (E-248)5 Juin 1984
- IBM TECHNICAL DISCLOSURE BULLETIN. vol. 28, no. 8, Janvier 1986, NEW YORK US pages 3551 - 3552 'GATE DIELECTRIC BREAKDOWN AVOIDANCE UTILIZING ZENER BREAKDOWN OF HEAVELY DOPED JUNCTIONS'

## Description

La présente invention concerne une structure de diode à avalanche dans un circuit intégré et notamment un circuit intégré de type BICMOS.

Les fabricants de circuits intégrés utilisent diverses filières technologiques pour fabriquer des circuits intégrés répondant à des besoins spécifiques. Ces filières technologiques se caractérisent notamment par le nombre d'étapes de diffusion (ou implantation) et le nombre d'étapes de masquage. Dans une filière technologique donnée, un souhait du concepteur réalisant un circuit intégré est de pouvoir disposer du plus grand nombre possible de composants élémentaires.

On s'intéressera ici plus particulièrement à la filière technologique BICMOS du type de celle qui est décrite dans la demande de brevet européen 0401135 déposée sous une priorité du 2 juin 1989 par la demanderesse au nom du même inventeur. Cette filière présente l'avantage de permettre la réalisation sur un même circuit intégré de transistors MOS complémentaires et de transistors bipolaires haute et basse tension.

Comme cela sera rappelé en relation avec les figures lA et 1B, cette filière prévoit trois types de couches enterrées réalisées dans un substrat de silicium avant croissance d'une couche épitaxiale dans laquelle seront formés les transistors MOS et bipolaires.

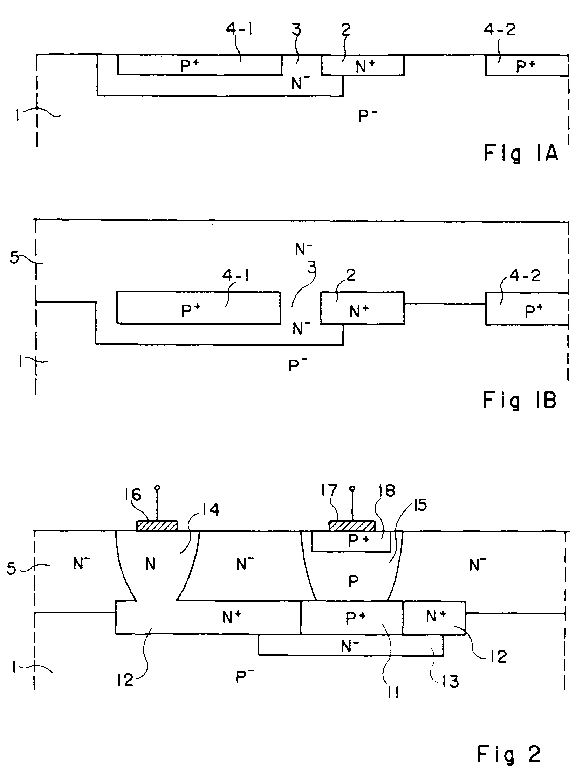

La figure 1A, représente de façon simplifiée une étape intermédiaire de ce processus technologique et correspond, de façon simplifiée, à la figure 4 de la demande de brevet susmentionnée.

A partir de la surface supérieure d'un substrat semiconducteur 1 de type P faiblement dopé, on a formé, généralement par implantation et recuit, des régions de type N fortement dopées 2, des régions de type N faiblement dopées 3, et des régions de type P fortement dopées 4-1 et 4-2. Les régions P fortement dopées peuvent être réalisées à l'intérieur de régions 3, comme cela est représenté pour la région 4-1.

L'état du dispositif à une étape ultérieure de fabrication est illustré en figure 1B qui correspond de façon simplifiée à la figure 5 de la demande de brevet susmentionnée. A cette étape, on a fait croître au-dessus de la structure telle qu'illustrée en figure 1A une couche épitaxiale 5 de type N faiblement dopée.

Des transistors peuvent être formés de façon connue dans la couche épitaxiée 5 à partir de la surface supérieure de la puce. De même, l'homme de métier sait y former des diodes à avalanche en utilisant des régions diffusées à partir de la surface supérieure. Dans ce cas, il est connu que des diffusions d'impuretés à partir de la surface ou des polarisations de couches isolantes de surface entraînent une dégradation de la tension de claquage de la jonction en cours d'utilisation. De plus, dans les réalisations connues, pour atteindre une tension de seuil relativement élevée (12 à 20 V), on est amené à utiliser plusieurs diodes en série.

Un objet de la présente invention est de réaliser une diode à avalanche dans la technologie susmentionnée.

US-A-4 872 039 décrit une diode enterrée latérale dans un circuit intégré formée par deux couches enterrées adjacentes.

Un autre objet de la présente invention est de réaliser une telle diode à avalanche de fabrication et de structure simple présentant des caractéristiques de tension d'avalanche bien déterminées et fiables dans le temps.

Un autre objet de la présente invention est de prévoir une telle diode à avalanche qui soit convenablement isolée des autres composants élémentaires réalisés dans la puce.

Pour atteindre ces objets, la présente invention prévoit une structure de diode à avalanche telle que définie en revendication 1.

Ces objets, caractéristiques et avantages ainsi que d'autres de la présente invention seront exposés en détail dans la description suivante de modes de réalisation particuliers faite en relation avec les figures jointes parmi lesquelles :
les figures 1A et 1B, décrites précédemment, décrivent des étapes intermédiaires de fabrication d'un circuit intégré dans une technologie BICMOS ; et
la figure 2 représente une vue en coupe schématique d'une diode à avalanche selon un mode de réalisation de la présente invention.

Toutes ces figures sont très schématiques et ne sont pas tracées à l'échelle. En outre, les formes, et notamment les formes latérales, des diverses couches ont été représentées par simplification avec des angles droits alors qu'en fait, comme cela est connu de l'homme de métier, les étapes de diffusion et de recuit amènent à des formes arrondies.

Comme le représente la figure 2, la présente invention utilise une structure obtenue par la technologie illustrée en figures 1A et 1B, comprenant sur un substrat 1 une couche épitaxiale 5. Une région enterrée 11 de type P fortement dopée (P⁺) est entourée d'une région enterrée 12 de type N fortement dopée (N⁺) de sorte qu'il existe un contact latéral continu entre ces régions. Une région enterrée 13 de type N faiblement dopée (N⁻) est disposée sous la région 11 et déborde par rapport à cette région. Cette région N⁻ 13, qui est au potentiel de la région N⁺ 12, isole du substrat la région P⁺ 11. Avec les niveaux de dopage classiques utilisés pour les couches enterrées P⁺ et N⁺, la tension d'avalanche de la jonction N⁺P⁺ entre les régions 12 et 11, quand cette jonction est polarisée en inverse, est de l'ordre de 10 à 20 volts. La réalisation d'une diode à avalanche présentant une telle tension de claquage est particulièrement utile en pratique pour servir de diode de protection de la tension d'alimentation, si cette tension d'alimentation est normalement de 12 volts.

On notera que, pour le fonctionnement de l'ensemble des circuits couramment réalisés dans la technologie considérée, le niveau de dopage précis des régions N⁺ et P⁺ n'est pas critique. En fait, la région N⁺ est toujours beaucoup plus fortement dopée que la région P⁺. En modulant le niveau de dopage de la région P⁺, tout en le conservant à une valeur élevée, on pourra ajuster la tension d'avalanche de la jonction N⁺P⁺ à une valeur sélectionnée, par exemple entre 12 et 16 V.

Pour réaliser à partir de la jonction N⁺P⁺ décrite précédemment une diode à avalanche connectée à des bornes externes, ou à d'autres contacts du circuit intégré, il faut établir des contacts avec cette jonction à partir de la surface supérieure du substrat. Ceci peut être fait par des diffusions profondes, à savoir une région diffusée de type N 14 qui s'étend entre la surface du substrat et la région 12, et une région diffusée profonde 15 de type P qui s'étend entre la surface du substrat et la région 11. Des contacts 16 et 17, par exemple des métallisations, pourront être établis sur la surface supérieure des régions 14 et 15. Si les diffusions profondes ont un niveau de diffusion insuffisant en surface, on pourra prévoir une région surdopée sous la métallisation. Une telle région 18 surdopée de type P a été représentée sous la métallisation 17.

Dans une application à la réalisation d'une diode de protection, la métallisation 16 sera reliée à la borne d'alimentation et la métallisation 17 à la masse.

Par ailleurs, un avantage de la diode à avalanche réalisée à partir de couches enterrées selon la présente invention est qu'elle est peu susceptible de dérive en cours de fonctionnement contrairement au cas de diodes superficielles.

## Revendications

1. Structure de diode à avalanche dans un circuit intégré, comprenant un substrat (1) d'un premier type de conductivité revêtue d'une couche épitaxiée (5) du deuxième type de conductivité, caractérisé en ce qu'elle comprend :
une première couche enterrée (11) à fort niveau de dopage du premier type de conductivité ;
une deuxième couche enterrée (12) à fort niveau de dopage du deuxième type de conductivité, entourant la première couche enterrée et en contact latéral avec celle-ci ; et
une troisième couche enterrée (13) à faible niveau de dopage du deuxième type de conductivité située sous, et en contact avec la première couche enterrée et en débordement par rapport à celle-ci pour s'étendre également sous une portion périphérique inférieure de la deuxième couche enterrée de façon à isoler la première couche enterrée (11) du substrat.

2. Structure de diode à avalanche selon la revendication 1, caractérisé en ce que des première et deuxième régions (15, 14) de diffusion profonde à fort niveau de dopage respectivement des premier et deuxième types de conductivité, rejoignent respectivement les première et deuxième couches enterrées (11, 12) à partir de la surface supérieure du circuit intégré, les surfaces supérieures des première et deuxième régions de diffusion profonde étant munies de contacts (17, 16).

3. Structure de diode à avalanche selon la revendication 2, caractérisé en ce que le premier type de conductivité est le type P et le deuxième type de conductivité est le type N.

## Patentansprüche

1. Lawinendioden-Struktur in einer integrierten Schaltung, welche ein Substrat (1) eines ersten Leitfähigkeitstyps und eine darüber befindliche Epitaxialdeckschicht (5) vom zweiten Leitfähigkeitstyp aufweist,
dadurch gekennzeichnet, daß die Struktur umfaßt:
- eine erste vergrabene Schicht (11) mit einem starken Dotierungspegel des ersten Leitfähigkeitstyps;
- eine zweite vergrabene Schicht (12) mit starkem Dotierungspegel des zweiten Leitfähigkeitstyps, welche die erste vergrabene Schicht umgibt und mit dieser einen seitlichen oder Lateralkontakt bildet; sowie
- eine dritte vergrabene Schicht (13) mit schwachem Dotierungspegel des zweiten Leitfähigkeitstyps, welche unterhalb der ersten vergrabenen Schicht und in Kontakt mit dieser angeordnet ist und über diese hinaussteht, derart daß sie sich auch unter einen unteren Umfangsteil der zweiten vergrabenen Schicht erstreckt und so die erste vergrabene Schicht (11) gegenüber dem Substrat isoliert.

2. Lawinendioden-Struktur nach Anspruch 1,
dadurch gekennzeichnet, daß erste bzw. zweite tiefe Diffusionsbereiche (15, 14) mit hohem Dotierungspegel vom ersten bzw. vom zweiten Leitfähigkeitstyp von der Oberseite der integrierten Schaltung aus zu den ersten bzw. zweiten vergrabenen Schichten (11, 12) reichen, wobei die Oberseiten der ersten bzw. zweiten tiefen Diffusionsbereiche mit Kontakten (17, 16) versehen sind.

3. Lawinendioden-Struktur nach Anspruch 2,
dadurch gekennzeichnet, daß der erste Leitfähigkeitstyp der P-Leitfähigkeitstyp und der zweite Leitfähigkeitstyp der N-Leitfähigkeitstyp ist.

## Claims

1. An avalanche diode structure incorporated in an integrated circuit, comprising a substrate (1) of a first conductivity type covered with an epitaxial layer of the second conductivity type, characterized in that it includes:
a first highly doped buried layer (11) of the first conductivity type;
a second highly doped buried layer (12) of the second conductivity type, surrounding said first buried layer and laterally contacting the latter; and
a third low doped buried layer (13) of the second conductivity type disposed beneath, and in contact with, said first buried layer and overlapping with respect to the latter so as to also extend under a lower peripheral portion of said second buried layer, so as to isolate the first buried layer (11) from the substrate.

2. An avalanche diode structure according to claim 1, characterized in that first and second highly doped and deeply diffused regions (15, 14), of first and second conductivity types, respectively contact said corresponding first and second buried layers (11, 12) from the upper surface of said integrated circuit, the upper surfaces of said first and second deeply diffused regions being provided with contacts (17, 16).

3. An avalanche diode structure according to claim 2, wherein said first conductivity type is P-type and said second conductivity type is N-type.
